# EUROPÄISCHE PATENTSCHRIFT

(11) **EP 3 649 835 B1**
(45) Veröffentlichungstag und Bekanntmachung des Hinweises auf die Patenterteilung: **20.12.2023**
(21) Anmeldenummer: 18726094.8
(22) Anmeldetag: 14.05.2018
(51) Int. Cl.: H05K 5/00, G01D 11/24

(54) **ELEKTRONIKMODUL UND KOMBINATION EINES ELEKTRONIKMODULS MIT EINER HYDRAULIKPLATTE**
ELECTRONIC MODULE AND COMBINATION OF AN ELECTRONIC MODULE AND A HYDRAULIC PLATE
MODULE ÉLECTRONIQUE ET COMBINAISON D'UN MODULE ÉLECTRONIQUE AVEC UNE PLAQUE HYDRAULIQUE

(30) Priorität: 06.07.2017 DE 102017211513
(43) Veröffentlichungstag der Anmeldung: 13.05.2020
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2018/062389
(87) Internationale Veröffentlichungsnummer: WO 2019/007573

(56) Entgegenhaltungen:
- EP-A1- 2 906 024
- WO-A1-2014/146614
- DE-A1- 19 834 212
- DE-A1-102005 002 813
- DE-A1-102015 209 191

## Beschreibung

### Stand der Technik

In der Kraftfahrzeugtechnik werden Elektronikmodule zur Ansteuerung eines Getriebes am oder im Getriebe verbaut. Die Elektronikmodule können beispielsweise als Getriebesteuermodule ausgelegt sein und außer einer auf einer Leiterplatte angeordneten Steuerschaltung beispielsweise zusätzlich noch Steckerteile, Sensoren und Kontaktierungsschnittstellen zu Aktuatoren aufweisen. Die elektronische Steuerschaltung und muss vor dem aggressiven Getriebefluid geschützt werden. Zu diesem Zweck werden auch Vergussmassen eingesetzt, die auf die Leiterplatte zum Schutz der elektronischen Steuerschaltung aufgebracht wird.

So ist beispielsweise aus der der DE 10 2011 085 629 A1 ein elektronisches Getriebesteuermodul bekannt, das ein metallisches Bechergehäuse aufweist und einen in dem Bechergehäuse angeordneten, mit elektronischen Bauelementen bestückten Schaltungsträger aufweist. Der Schaltungsträger ist zum Schutz vor dem aggressiven Getriebefluid und darin enthaltenen Metallspänen in dem Bechergehäuse mit einer Vergussmasse vergossen. Die Anschlusselemente ragen aus der Vergussmasse heraus und dienen teilweise zum Anschluss an die Spannungsversorgung, an einen EC-Motor, an Sensoren und/oder einen LIN- oder CAN-Bus. Das Bechergehäuse kann über schraubbare Befestigungsmittel an einem Gehäuseteil des Getriebes oder der Getriebehydraulik befestigt werden, über das auch die Kühlung des Steuergerätes erfolgen kann.

Weiterhin ist beispielsweise aus der DE 10 2013 205 155 A1 bekannt, ein pillenförmiges Drucksensorelement in einem Kunststoffträger zu verbauen und dort mit einem in den Kunststoffträger eingebetteten Stanzgittern elektrisch zu kontaktieren. Diese Baugruppe ist auf einer Trägerplatte eines Getriebesteuermoduls fixiert. Im Betrieb tritt Relaxation des Kunststoffbauteils auf, was durch eine mechanische Vorspannung des System kompensiert wird. Die Position des Drucksensors ist dabei fest vorgegebenen und kann ohne aufwändige Änderung des Gesamtaufbaus nicht verändert werden.

Ferner ist aus der DE 10 2015 205 445 ein Getriebesteuergerät mit einem Zentralmodul bekannt, das eine Trägerplatte und auf der Trägerplatte angeordnete elektronische Bauelemente und eine Vergussmasse als Abdeckung für die elektronischen Bauelemente umfasst, wobei das Zentralmodul eine Buchse mit einer Öffnung zur Aufnahme eines schraubbaren Befestigungsmittels aufweist, um das Zentralmodul an dem Getriebe zu befestigen.

Aus der DE 10 2015 209191 A1 ist ein Elektronikmodul mit einer Leiterplatte, welche eine erste Seite und eine davon abgewandte zweite Seite aufweist, mit auf der ersten Seite angeordneten elektronischen Bauelementen und mit einer auf der ersten Seite angeordneten Vergussmasse bekannt, welche die elektronischen Bauelemente abdeckt. Die Leiterplatte weiste einen die erste Seite mit der zweiten Seite verbindenden Durchbruch auf, wobei ein den Durchbruch abdeckendes Sensorelement an der ersten Seite der Leiterplatte angeordnet ist.

Aus der DE 198 34 212 A1 ist ein Steuergerät bekannt, das eine Steuerschaltung und einen Drucksensor aufweist, die in einem gemeinsamen Gehäuse untergebracht sind. Das Gehäuse hat eine metallische Grundplatte, die druckdicht mit einer Hydraulikeinheit eines Getriebes verbunden und mit einer Bohrung versehen ist, durch die der Drucksensor mit Druck beaufschlagt wird.

Weitere Elektronikmodule, die Leiterplatten mit darauf angeordneten und von einer Vergussmasse abgedeckten elektronischen Bauelementen aufweisen, sind aus der EP 2 906 024 A1, der DE 10 2005 002 813 A1 und der WO 2014/146614 A1 bekannt.

### Offenbarung der Erfindung

Die Erfindung betrifft ein Elektronikmodul, insbesondere ein Steuermodul oder ein Sensormodul für ein Getriebe, mit einer Leiterplatte, welche eine erste Seite und eine davon abgewandte zweite Seite aufweist, mit auf der ersten Seite angeordneten elektronischen Bauelementen und mit einer auf der ersten Seite angeordneten Vergussmasse, welche die elektronischen Bauelemente abdeckt, wobei die Leiterplatte einen die erste Seite mit der zweiten Seite verbindenden Durchbruch aufweist und ein den Durchbruch abdeckendes Sensorelement an der ersten Seite der Leiterplatte angeordnet ist. Erfindungsgemäß wird vorgeschlagen, dass eine Buchse zur Aufnahme eines schraubbaren Verbindungsmittels an der Leiterplatte angeordnet ist, wobei die Buchse von der auf die ersten Seite der Leiterplatte aufgetragenen Vergussmasse umlaufend flankiert ist und eine nicht mit der Vergussmasse abgedeckte Stirnseite aufweist, von der sich eine Aufnahmeöffnung bis zu der zweiten Seite der Leiterplatte erstreckt.

Weiterhin betrifft die Erfindung eine Kombination eines derartigen Elektronikmoduls mit einer Hydraulikplatte, wobei das Elektronikmodul mit der zweiten Seite der Leiterplatte an einer Oberfläche der Hydraulikplatte flach anliegt und die Hydraulikplatte einen an der Oberfläche mündenden Mediumkanal aufweist, wobei der Mediumkanal mit dem Sensorelement in einer Fluidverbindung steht.

### Vorteile der Erfindung

Vorteilhaft kann bei dem erfindungsgemäßen Elektronikmodul die Lage eines Sensorelementes in dem Elektronikmodul ohne großen Aufwand geändert und an das jeweilige Anforderungsprofil angepasst werden. Bei notwendigen Designänderungen der Position des Sensorelementes an dem Elektronikmodul kann diese Änderung daher in sehr kurzer Zeit umgesetzt werden. Bei einer Änderung des Designs muss vorteilhaft nur das Leiterplatten-Layout in Hinblick auf die Lage des Durchbruchs und der elektrischen Anschlüsse des Sensorelementes angepasst werden. Vorteilhaft ist kein separater Kunststoffträger zur Anordnung des Sensorelements erforderlich und die Kosten für einen derartigen Kunststoffträger entfallen. Ebenso entfallen die mit der unterschiedlichen Wärmeausdehnung von Kunststoffträger und Leiterplatte verbundenen Schwierigkeiten. Das Sensorelement, beispielsweise ein Drucksensorelement, wird in einfacher Weise an der ersten Seite der Leiterplatte derart angeordnet, dass es dort einen zur Zuführung des Messmediums vorgesehenen Durchbruch abdeckt. Die Leiterplatte wird durch den Einbau des Sensorelementes und bei einer Belastung des Sensorelementes mit hydraulischem Druck mechanisch nicht belastet, wodurch die Gefahr einer Beschädigung vermieden wird.

Der Einbau des Sensorelements kann vor oder nach dem Bestücken und Auflöten von elektronischen Bauelementen auf die Leiterplatte erfolgen. Im letzteren Fall kann bei hohen Löttemperaturen eines Lötofens, die beispielsweise zur Verlötung von bleifreien Loten notwendig sind, vorteilhaft erreicht werden, dass die Ofentemperatur nicht zum Aufschmelzen der Lötverbindungen im Sensorelement selbst führt.

Zur mechanischen Festlegung des elektronischen Elektronikmoduls an einem Getriebebauteil ist erfindungsgemäß wenigstens eine Buchse zur Aufnahme eines schraubbaren Verbindungsmittels an der Leiterplatte angeordnet, wobei die Buchse von der auf der ersten Seite der Leiterplatte aufgetragenen Vergussmasse umlaufend flankiert ist und eine nicht mit der Vergussmasse abgedeckte Stirnseite aufweist, von der sich eine Aufnahmeöffnung bis zu der zweiten Seite der Leiterplatte erstreckt. Dadurch wird vorteilhaft erreicht, dass ein in die Aufnahmeöffnung eingeführte schraubbares Verbindungsmittel beim Festziehen die Spannkraft auf die Stirnseite der Buchse überträgt. Die Buchse wiederum kann sich auf der zweiten Seite der Leiterplatte direkt am Getriebebauteil abstützen, so dass eine Krafteinleitung auf die Leiterplatte beim Festziehen der Schraube vermieden wird. Beim Anliegen eines Hydraulikdrucks erfährt das Sensorelement eine Druckkraft. Da das Sensorelement fest an dem elektronischen Elektronikmodul verbaut ist, wird diese Kraft vorteilhaft von den angeschraubten Buchsen aufgenommen. Die Leiterplatte erfährt hierbei vorteilhaft keine unzulässig hohen Press- oder Zugkräfte. Natürlich können auch mehrere Buchsen an dem Elektronikmodul vorgesehen sein.

Vorteilhafte Ausgestaltungen und Weiterbildungen der Erfindung werden durch die in den abhängigen Ansprüchen enthaltenen Merkmale ermöglicht.

Vorteilhaft kann das Sensorelement den Durchbruch vollständig abdecken und auf der ersten Seite der Leiterplatte mit der Vergussmasse abgedeckt sein, wodurch das Sensorelement mechanisch stabil an dem Elektronikmodul angeordnet und vor dem aggressiven Getriebefluid und darin enthaltenen Metallspänen ausreichend geschützt ist. Vorteilhaft sind zur Festlegung des Sensorelementes an der Leiterplatte keine Befestigungsschrauben oder Nieten erforderlich, die Flächen und Freiraum auf der Leiterplatte benötigen würden. Durch die Verwendung einer Vergussmasse, beispielsweise einen duroplastischen Werkstoffs, zur mechanischen Festlegung des Sensorelements tritt bei Temperaturschwankungen und Alterung des Elektronikmoduls keine Relaxation auf, so dass sich die Lage des Sensorelementes an dem Elektronikmodul bei Druckbelastung und Alterung des Elektronikmoduls vorteilhaft nicht verändert.

Vorteilhaft können elektrische Verbindungsmittel, welche das Sensorelement mit der Leiterplatte elektrisch verbinden, in die Vergussmasse eingebettet sein. Die elektrischen Verbindungsmittel zwischen dem Sensorelement und der Leiterplatte können beispielsweise mittels Kabelverbindungen, Stanzgittern oder flexiblen Leiterplatten (FPC = Flexible Printed Circuit) aus Polyimid oder FR4-Material erfolgen. Durch die Einbettung in die Vergussmasse sind die elektrischen Verbindungsmittel gegen Kurzschlüsse, welche durch Metallspäne im Getriebefluid entstehen können, und gegen chemische Belastungen geschützt.

Vorteilhaft kann das Sensorelement in den Durchbruch eingesetzt sein, wodurch ein relaxationsfreier Einbau gelingt, der ohne Federn auskommt und Druck- sowie Zugbelastungen der Leiterplatte minimiert. Das Sensorelement kann zu diesem Zweck vorteilhaft einen umlaufenden Kragen aufweisen, der am Rand des Durchbruchs auf der ersten Seite der Leiterplatte aufliegt. Vorteilhaft kann das Sensorelement bei einem der letzten Herstellungsschritte des Elektronikmoduls an der Leiterplatte durch einfaches Einsetzen montiert und gleichzeitig elektrisch kontaktiert werden.

Falls das an der ersten Seite der Leiterplatte angeordnete Sensorelement eine relativ große Bauhöhe aufweist, kann dort vorteilhaft ein das Sensorelement umgebendes Rahmenteil angeordnet sein, innerhalb dessen die Vergussmasse mit einer größeren Füllhöhe als in einem Bereich außerhalb des Rahmenteils auf die ersten Seite der Leiterplatte aufgetragen ist. Unter Füllhöhe wird in diesem Zusammenhang die Materialstärke beziehungsweise Dicke der Vergussmasse in einer Richtung senkrecht zur ersten Seite der Leiterplatte verstanden.

Weiterhin vorteilhaft ist eine Kombination des beschriebenen Elektronikmoduls mit einer Hydraulikplatte, wobei das Elektronikmodul mit der zweiten Seite der Leiterplatte an einer Oberfläche der Hydraulikplatte flach anliegt und die Hydraulikplatte einen an der Oberfläche der Hydraulikplatte mündenden Mediumkanal aufweist, wobei der Mediumkanal mit dem Sensorelement in einer Fluidverbindung steht. Das Medium kann ein Gas oder eine Flüssigkeit und insbesondere Getriebefluid sein.

Zur Abdichtung des Mediumkanals kann in einfacher Weise vorteilhaft vorgesehen sein, dass der Mediumkanal beispielsweise einen Absatz aufweist, an dem ein Dichtungsring angeordnet ist, der zwischen einem in den Durchbruch hineinragenden Abschnitt des Sensorelements und dem Absatz eingepresst ist.

### Kurze Beschreibung der Zeichnungen

Es zeigen:
Fig. 1 einen Querschnitt durch ein Ausführungsbeispiel eines erfindungsgemäßen Elektronikmoduls,
Fig. 2 bis Fig. 4 einzelne Fertigungsschritte bei der Herstellung des Elektronikmoduls,
Fig. 5 einen Querschnitt durch eine Ausführungsbeispiel einer Kombination eines Elektronikmoduls mit einer Hydraulikplatte
Fig. 6 eine Ausführungsform einer an dem Elektronikmodul verbauten Schraubenbuchse.

### Ausführungsformen der Erfindung

Bei dem Elektronikmodul kann es sich beispielsweise um ein Steuermodul zur Ansteuerung eines Aggregats oder um ein Sensormodul mit mehreren Sensoren handeln. Insbesondere handelt es ich um ein Getriebesteuermodul oder eine Sensormodul für ein Getriebe.

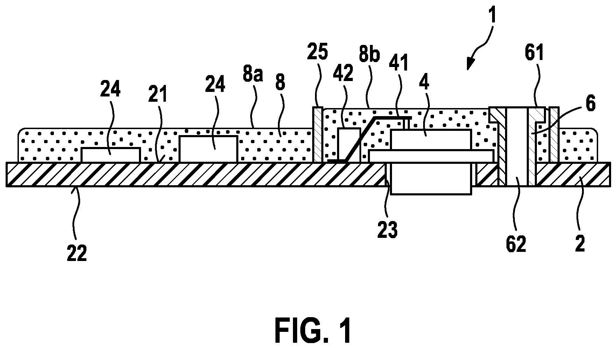

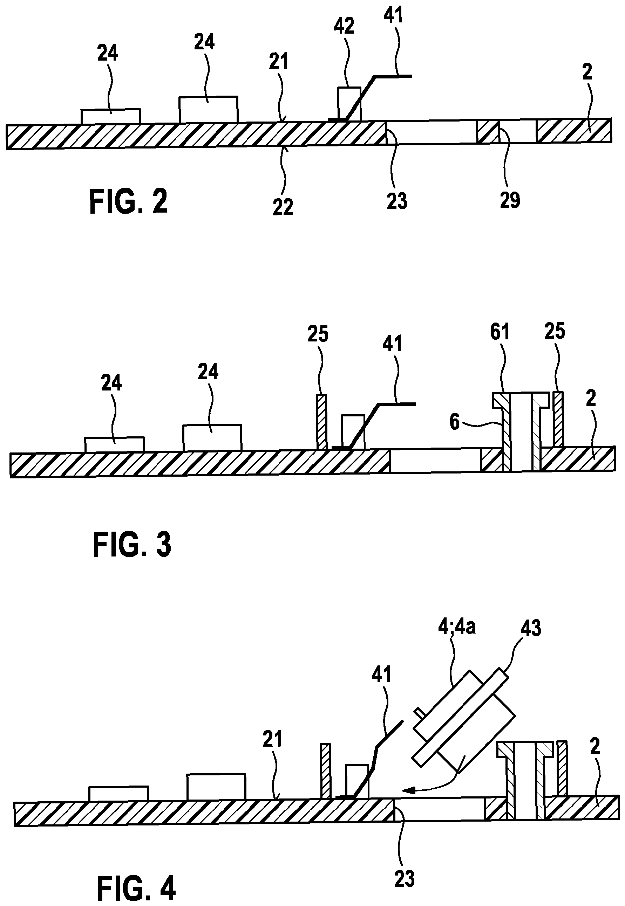

Der Aufbau eines in Fig. 1 dargestellten Elektronikmoduls 1 wird im Folgenden anhand des in Fig. 2 bis Fig. 4 dargestellten Herstellungsverfahren beschrieben.

Zunächst wird, wie in Fig. 2 gezeigt, eine Leiterplatte 2, welche eine erste Seite 21 und eine davon abgewandte zweite Seite 22 aufweist, mit elektronischen Bauelementen 24 und einer Kontaktbaugruppe 42 bestückt. Die elektronischen Bauelemente 24, können beispielsweise eine elektronische Steuerschaltung bilden und in Standardprozessen auf die Leiterplatte 2 aufgebracht und kontaktiert werden. Hierzu zählen beispielsweise Aufkleben und Bonden von Bare-Die-Bauelementen ebenso wie das Bestücken und Reflowlöten von gehäusten elektronischen Bauelementen. Bei der Leiterplatte 2 kann es sich um eine konventionelle FR4-Leiterplatte aus glasfaserverstärktem Epoxidharz mit in einer oder mehreren Lagen angeordneten Kupferleiterbahnen handeln. Die Leiterplatte 2 ist mit einem Durchbruch 23 versehen, der sich ausgehend von der ersten Seite 21 bis zu der zweiten Seite 22 hindurch erstreckt. Der Durchbruch 23 kann beispielsweise durch Fräsen oder Bohren in die Leiterplatte 2 eingebracht werden. Außerdem weist die Leiterplatte beispielsweise eine weitere als Bohrung ausgebildete Ausnehmung 29 auf. An der Kontaktbaugruppe 42 können elektrische Verbindungsmittel 41 angeordnet sein, welche beispielsweise als Stanzgitterteil, flexible Leiterplatte oder Kabel ausgebildet sein können. Die elektronischen Bauelemente 24 und die Kontaktbaugruppe 42 mit den elektrischen Verbindungsmitteln 41 können beispielsweise in einem Lötofen mit Kontaktflächen auf der ersten Seite 21 der Leiterplatte 2 verlötet werden.

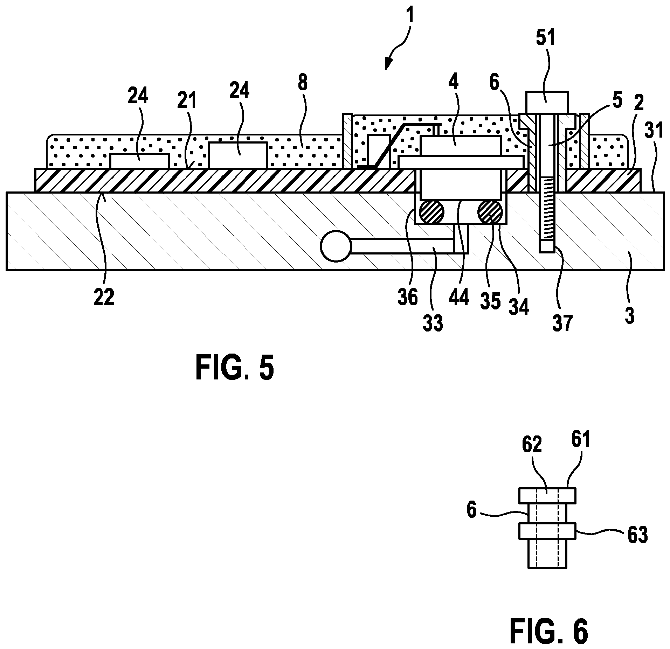

Wie in Fig. 3 dargestellt, kann ein Rahmenteil 25 auf der ersten Seite 21 der Leiterplatte angeordnet werden, das den Durchbruch 23 und die Kontaktbaugruppe 41 umlaufend umgibt. Das Rahmenteil kann aus Metall oder Kunststoff oder mittels eines zähflüssigen und schnell härtenden Kleberauftrags hergestellt werden. Weiterhin ist eine metallische Buchse 6 in die Ausnehmung 29 eingepresst. Die Buchse 6 weist eine von der ersten Seite 21 der Leiterplatte 2 abweisende Stirnseite 61 aufweist, von der aus sich eine Aufnahmeöffnung 62 bis zu der zweiten Seite 22 der Leiterplatte 2 erstreckt. Die Buchse 6 kann zusätzlich zum Einpressen in die Ausnehmung 29 noch mit einer Kontaktfläche auf der ersten Seite der Leiterplatte 2 verlötet werden. Wie in Fig. 6 gezeigt kann die Buchse 6 einen umlaufenden Kragen 63 zur Anlage an der ersten Seite 21 der Leiterplatte 2 aufweisen. Die Leiterplatte 2 kann in dem in Fig. 2 oder Fig. 3 dargestellten Zustand im Lötofen verlötet werden.

Wie in Fig. 4 gezeigt, kann ein Sensorelement 4, beispielsweise ein Drucksensorelement 4a in den Durchbruch 23 eingesetzt werden. Das Sensorelement 4 kann einen umlaufenden Kragen 43 aufweisen, der am Rand des Durchbruchs 23 auf der ersten Seite 21 der Leiterplatte 2 zur Anlage gelangt. Dabei wird das Sensorelement 4 unter die flexibel ausgestalteten Verbindungsmittel 41 geschoben, die zu diesem Zweck angehoben werden können. Das Sensorelement 4 deckt den Durchbruch 23 vorzugsweise vollständig ab, um bei einer Auftragung von Vergussmasse ein Ablaufen derselben durch den Durchbruch 23 zu vermeiden. Die elektrische Kontaktierung zwischen dem Sensorelement 4 und den Verbindungsmitteln 4 kann nach dem Einsetzen des Sensorelementes 4 beispielsweise durch Laserschweißen oder mit einer Lötspitze oder anderem Selektivlötverfahren erfolgen. In der gleichen Weise kann wenigstens ein oder auch mehrere Sensorelemente 4 an der Leiterplatte 2 montiert werden.

Schließlich wird, wie in Fig. 1 gezeigt ist, eine Vergussmasse 8 auf die erste Seite 21 der Leiterplatte aufgetragen. Hierzu kann die Vergussmasse 8 in einem ersten Füllbereich 8a außerhalb des Rahmenteils 25 und gleichzeitig in einem zweiten Füllbereich 8b mit größerer Füllhöhe innerhalb des Rahmenteils 25 eingefüllt werden. Die Vergussmasse 8 kann mit einem Dispenskopf aufgetragen werden. Ein Ablaufen der Vergussmasse 8 aus dem ersten Füllbereich 8a kann mit einem auf der ersten Seite angeordneten, nicht dargestellten umlaufenden Damm verhindert werden. Die Vergussmasse 8 deckt die elektronischen Bauelemente 24, die Kontaktbaugruppe mit den Verbindungsmitteln 41 und das Sensorelement 4 auf der ersten Seite 21 der Leiterplatte 2 vollständig ab. Die Vergussmasse 8 kann anschließend ausgehärtet werden. Vorteilhaft wird kein Spritzguss- oder Mold-Werkzeug benötigt. Als Vergussmasse 8 kann ein Duroplast, insbesondere ein Epoxidharz verwendet werden, beispielsweise ein Epoxidharz mit einem CTE (CTE = Coefficient of Thermal Expansion) im Bereich von 18-25 ppm/K. Dies passt zur Leiterplatte mit einem CTE von 18 ppm/K, dem Sensorelement mit Stahlgehäuse und einem CTE von 20 ppm/K, den elektronischen Bauelementen 24 und dem Rahmenteil 25 und der Kontaktbaugruppe 42 aus Duroplast mit einem CTE zwischen 10 und 40 ppm/K, sowie der Buchse 6 aus Stahl mit einem CTE von 20 ppm/K.

Das Elektronikmodul 1 kann beispielsweise, wie in Fig. 5 gezeigt, mit der zweiten Seite 22 der Leiterplatte 2 an einer ebenen Oberfläche 31 einer Hydraulikplatte 3 eines Kraftfahrzeuggetriebes flach aufgelegt werden. Die Hydraulikplatte 3 kann einen an der Oberfläche 31 der Hydraulikplatte 3 mündenden Mediumkanal 33, beispielsweise einen Hydraulikkanal aufweisen. Das Elektronikmodul 1 wird dabei derart an der Hydraulikplatte montiert, dass der Mediumkanal 33 mit dem Sensorelement 4 in einer Fluidverbindung steht. Der Mediumkanal 33 kann einen als Absenkung 36 ausgebildeten Abschnitt aufweisen, dessen Boden einen horizontalen Absatz 34 aufweist, an dem ein Dichtungsring 35 angeordnet ist, der zwischen einem in den Durchbruch 23 hineinragenden Abschnitt 44 des Sensorelements 4 und dem Absatz 34 eingepresst ist. Das Elektronikmodul 1 kann mittels schraubbarer Verbindungsmittel 5, deren Schraubenköpfe 51 sich an der Stirnseite 61 der Buchse 6 abstützen, in Gewindebohrungen 37 der Hydraulikplatte 3 festgeschraubt werden. Die schraubbaren Verbindungsmittel 5 drücken das gesamt Elektronikmodul 1 gegen die Hydraulikplatte 3 an.

Ein in dem Mediumkanal 33 herrschender Fluiddruck wirkt im Betrieb auf das als Drucksensorelement 4a ausgebildete Sensorelement 4. Da das Sensorelement 4 über die Vergussmasse 8 fest an dem Elektronikmodul 1 verbaut ist, wird die auf das Elektronikmodul 1 übertragene Kraft vorteilhaft von den angeschraubten Buchsen 6 aufgenommen.

## Patentansprüche

1. Elektronikmodul (1), insbesondere Steuermodul oder Sensormodul für ein Kraftfahrzeuggetriebe, mit einer Leiterplatte (2), welche eine erste Seite (21) und eine davon abgewandte zweite Seite (22) aufweist, mit auf der ersten Seite (21) angeordneten elektronischen Bauelementen (24) und mit einer auf der ersten Seite (21) angeordneten Vergussmasse (8), welche die elektronischen Bauelemente (24) abdeckt, wobei die Leiterplatte (2) einen die erste Seite (21) mit der zweiten Seite (22) verbindenden Durchbruch (23) aufweist und ein den Durchbruch (23) abdeckendes Sensorelement (4) an der ersten Seite (21) der Leiterplatte (2) angeordnet ist, **dadurch gekennzeichnet, dass** eine Buchse (6) zur Aufnahme eines schraubbaren Verbindungsmittels (5) an der Leiterplatte (2) angeordnet ist, wobei die Buchse (6) von der auf die ersten Seite (21) der Leiterplatte (2) aufgetragenen Vergussmasse (8) umlaufend flankiert ist und eine nicht mit der Vergussmasse (8) abgedeckte Stirnseite (61) aufweist, von der sich eine Aufnahmeöffnung (62) bis zu der zweiten Seite (22) der Leiterplatte (2) erstreckt.

2. Elektronikmodul nach Anspruch 1, **dadurch gekennzeichnet, dass** das Sensorelement (4) den Durchbruch (23) vollständig abdeckt und dass das Sensorelement (4) auf der ersten Seite (21) der Leiterplatte (2) mit der Vergussmasse (8) abgedeckt ist.

3. Elektronikmodul nach Anspruch 1 oder 2, **dadurch gekennzeichnet, dass** elektrische Verbindungsmittel (41), welche das Sensorelement (4) mit der Leiterplatte (2) elektrisch verbinden, in die Vergussmasse (8) eingebettet sind.

4. Elektronikmodul nach einem der vorstehenden Ansprüche, **dadurch gekennzeichnet, dass** das Sensorelement (4) in den Durchbruch (23) eingesetzt ist.

5. Elektronikmodul nach einem der vorstehenden Ansprüche, **dadurch gekennzeichnet, dass** das Sensorelement (4) einen umlaufenden Kragen (43) aufweist, der am Rand des Durchbruchs (23) auf der ersten Seite (21) der Leiterplatte (2) aufliegt.

6. Elektronikmodul nach einem der vorstehenden Ansprüche, **dadurch gekennzeichnet, dass** das Sensorelement (4) ein Drucksensorelement (4a) ist.

7. Elektronikmodul nach einem der vorstehenden Ansprüche, **dadurch gekennzeichnet, dass** auf der ersten Seite (21) der Leiterplatte (2) ein das Sensorelement (4) umgebendes Rahmenteil (25) angeordnet ist, innerhalb dessen die Vergussmasse (8) mit einer größeren Füllhöhe als in einem Bereich außerhalb des Rahmenteils (25) auf die ersten Seite (21) der Leiterplatte aufgetragen ist.

8. Kombination eines Elektronikmoduls (1) nach einem der vorstehenden Ansprüche 1 bis 7 mit einer Hydraulikplatte (3), wobei das Elektronikmodul (1) mit der zweiten Seite (22) der Leiterplatte (2) an einer Oberfläche (31) der Hydraulikplatte (3) flach anliegt und die Hydraulikplatte (3) einen an der Oberfläche (31) der Hydraulikplatte (3) mündenden Mediumkanal (33) aufweist, wobei der Mediumkanal (33) mit dem Sensorelement (4) in einer Fluidverbindung steht.

9. Kombination eines Elektronikmoduls nach Anspruch 8, **dadurch gekennzeichnet, dass** der Mediumkanal (33) einen Absatz (34) aufweist, an dem ein Dichtungsring (35) angeordnet ist, der zwischen einem in den Durchbruch (23) hineinragenden Abschnitt des Sensorelements (4) und dem Absatz (34) eingepresst ist.

## Claims

1. Electronics module (1), in particular control module or sensor module for a motor vehicle transmission, comprising a printed circuit board (2) which has a first side (21) and a second side (22) which is averted from said first side, comprising electronic components (24) which are arranged on the first side (21) and comprising a potting compound (8) which is arranged on the first side (21) and covers the electronic components (24), wherein the printed circuit board (2) has an aperture (23) which connects the first side (21) to the second side (22), and a sensor element (4), which covers the aperture (23), is arranged on the first side (21) of the printed circuit board (2), **characterized in that** a bush (6) for receiving a screwable connecting means (5) is arranged on the printed circuit board (2), wherein the bush (6) is flanked in a circumferential manner by the potting compound (8), which is applied to the first side (21) of the printed circuit board (2), and has an end side (61) which is not covered by the potting compound (8) and from which a receiving opening (62) extends as far as the second side (22) of the printed circuit board (2) .

2. Electronics module according to Claim 1, **characterized in that** the sensor element (4) completely covers the aperture (23), and **in that** the sensor element (4) is covered by the potting compound (8) on the first side (21) of the printed circuit board (2).

3. Electronics module according to Claim 1 or 2, **characterized in that** electrical connecting means (41), which electrically connect the sensor element (4) to the printed circuit board (2), are embedded into the potting compound (8).

4. Electronics module according to one of the preceding claims, **characterized in that** the sensor element (4) is inserted into the aperture (23).

5. Electronics module according to one of the preceding claims, **characterized in that** the sensor element (4) has a circumferential collar (43) which rests on the first side (21) of the printed circuit board (2) at the edge of the aperture (23).

6. Electronics module according to one of the preceding claims, **characterized in that** the sensor element (4) is a pressure sensor element (4a).

7. Electronics module according to one of the preceding claims, **characterized in that** a frame part (25), which surrounds the sensor element (4) and within which the potting compound (8) is applied to the first side (21) of the printed circuit board (2) with a greater filling level than in a region outside the frame part (25), is arranged on the first side (21) of the printed circuit board.

8. Combination of an electronics module (1) according to one of the preceding Claims 1 to 7 with a hydraulic plate (3), wherein the electronics module (1), by way of the second side (22) of the printed circuit board (2), bears flat against a surface (31) of the hydraulic plate (3) and the hydraulic plate (3) has a medium channel (33) which issues at the surface (31) of the hydraulic plate (3), wherein the medium channel (33) is fluidically connected to the sensor element (4).

9. Combination of an electronics module according to Claim 8, **characterized in that** the medium channel (33) has a projection (34) on which a sealing ring (35) is arranged, said sealing ring being pressed in between a section of the sensor element (4) which protrudes into the aperture (23) and the projection (34).

## Revendications

1. Module électronique (1), en particulier module de commande ou module de capteur pour une boîte de vitesses de véhicule automobile, comprenant une carte de circuits imprimés (2) qui présente une première face (21) et une deuxième face (22) détournée de celle-ci, comprenant des composants électroniques (24) disposés sur la première face (21) et une masse de scellement (8) disposée sur la première face (21) et qui recouvre les composants électroniques (24), dans lequel la carte de circuits imprimés (2) présente une traversée (23) reliant la première face (21) à la deuxième face (22), et un élément capteur (4) recouvrant la traversée (23) est disposé sur la première face (21) de la carte de circuits imprimés (2), **caractérisé en ce qu'**une douille (6) pour recevoir un moyen de liaison à visser (5) est disposée sur la carte de circuits imprimés (2), dans lequel la douille (6) est encadrée en périphérie par la masse de scellement (8) appliquée sur la première face (21) de la carte de circuits imprimés (2) et présente une face frontale (61) non recouverte par la masse de scellement (8) à partir de laquelle s'étend une ouverture de réception (62) jusqu'à la deuxième face (22) de la carte de circuits imprimés (2).

2. Module électronique selon la revendication 1, **caractérisé en ce que** l'élément capteur (4) recouvre entièrement la traversée (23), et **en ce que** l'élément capteur (4) est recouvert par la masse de scellement (8) sur la première face (21) de la carte de circuits imprimés (2) .

3. Module électronique selon la revendication 1 ou 2, **caractérisé en ce que** des moyens de liaison électrique (41) qui relient électriquement l'élément capteur (4) à la carte de circuits imprimés (2) sont incorporés dans la masse de scellement (8).

4. Module électronique selon l'une quelconque des revendications précédentes, **caractérisé en ce que** l'élément capteur (4) est inséré dans la traversée (23).

5. Module électronique selon l'une quelconque des revendications précédentes, **caractérisé en ce que** l'élément capteur (4) présente une collerette périphérique (43) qui repose au bord de la traversée (23) sur la première face (21) de la carte de circuits imprimés (2) .

6. Module électronique selon l'une quelconque des revendications précédentes, **caractérisé en ce que** l'élément capteur (4) est un élément capteur de pression (4a) .

7. Module électronique selon l'une quelconque des revendications précédentes, **caractérisé en ce que** sur la première face (21) de la carte de circuits imprimés (2) est disposée une pièce formant cadre (25) entourant l'élément capteur (4), à l'intérieur de laquelle la masse de scellement (8) est appliquée à une hauteur de remplissage supérieure à celle dans une zone à l'extérieur de la pièce formant cadre (25) sur la première face (21) de la carte de circuits imprimés.

8. Combinaison d'un module électronique (1) selon l'une quelconque des revendications précédentes 1 à 7, comprenant une plaque hydraulique (3), dans laquelle le module électronique (1) s'applique par la deuxième face (22) de la carte de circuits imprimés (2) contre une surface (31) de la plaque hydraulique (3) et la plaque hydraulique (3) présente un conduit de milieu (33) débouchant à la surface (31) de la plaque hydraulique (3), le conduit de milieu (33) étant en communication fluidique avec l'élément capteur (4).

9. Combinaison d'un module électronique selon la revendication 8, **caractérisée en ce que** le conduit de milieu (33) présente un épaulement (34) contre lequel est disposé une bague d'étanchéité (35) qui est pressée entre une partie de l'élément capteur (4) faisant saillie dans la traversée (23) et l'épaulement (34).
